(19) Europäisches Patentamt
European Patent Office
Office européen des brevets

(11) **EP 1 273 098 B1**

(12) **EUROPÄISCHE PATENTSCHRIFT**

(45) Veröffentlichungstag und Bekanntmachung des Hinweises auf die Patenterteilung:
**06.05.2004  Patentblatt 2004/19**

(21) Anmeldenummer: **00990758.5**

(22) Anmeldetag: **14.12.2000**

(51) Int Cl.$^7$: **H03F 1/00**

(86) Internationale Anmeldenummer:
**PCT/EP2000/012750**

(87) Internationale Veröffentlichungsnummer:
**WO 2001/069778 (20.09.2001 Gazette 2001/38)**

(54) **VERFAHREN ZUR BESTIMMUNG VON PARAMETERN EINES N-TORS**

METHOD FOR DETERMINING THE PARAMETERS OF AN N-GATE

PROCEDE POUR DETERMINER DES PARAMETRES D'UN ELEMENT A N ACCES

(84) Benannte Vertragsstaaten:
**DE FI FR GB IT SE**

(30) Priorität: **16.03.2000  DE 10012829**
          **10.05.2000  DE 10022853**

(43) Veröffentlichungstag der Anmeldung:
**08.01.2003  Patentblatt 2003/02**

(73) Patentinhaber: **Rohde & Schwarz GmbH & Co. KG**
**D-81671 München (DE)**

(72) Erfinder:
• **WEISS, Martin**
**83607 Holzkirchen (DE)**
• **SCHMIDT, Kurt**
**85567 Grafing (DE)**
• **MINIHOLD, Roland**
**80639 München (DE)**
• **WINTER, Albert**
**85661 Forstinning (DE)**

(74) Vertreter: **Körfer, Thomas, Dipl.-Phys. et al**
**Mitscherlich & Partner,**
**Patent- und Rechtsanwälte,**
**Sonnenstrasse 33**
**80331 München (DE)**

(56) Entgegenhaltungen:
DE-A- 19 813 703          US-A- 4 710 932
US-A- 5 168 459

EP 1 273 098 B1

**Beschreibung**

Die Erfindung betrifft ein Verfahren zur Bestimmung von Parametern eines n-Tors, insbesondere ein Verfahren zur Bestimmung von linearen und nicht linearen Kennlinien eines Hochfrequenz-Leistungsverstärkers.

Ein Verfahren nach dem Oberbegriff des Anspruchs 1 ist aus der DE 198 13 703 A1 bekannt. Bei Hochfrequenzverstärkern insbesondere zur Übertragung eines breitbandigen Signals wie eines CDMA-Signals, sind besondere Anforderungen an die Linearität der Verstärkungskennlinie und Phasengang-Kennlinie zu stellen, die von den aktiven Bauelementen nicht ohne weiteres erfüllt werden können. Eine Möglichkeit zur Linearisierung dieser Kennlinien besteht darin, eine Vorverzerrung des Eingangssignals des Verstärkers vorzunehmen, die invers zu derjenigen Verzerrung ist, die das Signal in dem Verstärker erfährt. Um eine solche Vorverzerrung vornehmen zu können, ist es notwendig die Kennlinien des Verstärkers und die für die Vorverzerrung benötigten inversen Kennlinien zu bestimmen. Das erfindungsgemäße Verfahren eignet sich jedoch nicht nur zur Bestimmung von Kennlinien eines Hochfrequenz-Verstärkers, welcher als 2-Tor aufgefaßt werden kann, sondern allgemein zur Bestimmung von Parametern eines n-Tors, beispielsweise eines Mischers, der als 3-Tor aufgefaßt werden kann.

Die DE 198 13 703 A1 offenbart ferner ein Verfahren zum Bestimmen der Kennlinien eines nicht linearen Leistungsverstärkers und zur automatischen Abstimmung eines dem Leistungsverstärker vorgeschalteten Vorverzerrers. Bei dem aus dieser Druckschrift bekannten Verfahren wird mittels eines Synchrondemodulators das Eingangssignal des Verstärkers in eine Hüllkurve und in eine Referenzträger aufgespalten. Dieser Referenzträger wird dem am Ausgang des Leistungsverstärkers vorgesehenen Synchrondemodulatoren zugeführt, um mit dem Referenzträger eine phasenkohärente Demodulation in die Inphase-Komponente und die Quadratur-Komponente des Ausgangssignals vornehmen zu können. Dabei ist eine entsprechende Anzeigeeinrichtung zur Anzeige der Amplituden-Kennlinie und der Phasen-Kennlinie vorgesehen. Gleichzeitig wird der auf diese Weise gewonnen Kennlinienverlauf einem digitalem Signalprozessor zugeführt, der die Vorverzerrung so regelt, daß eine möglichst lineare Amplituden-Kennlinie und eine möglichst konstante Phasen-Kennlinie erzeugt wird. Dieses während des Betriebs des Verstärkers durchgeführte Verfahren setzt allerdings voraus, daß das Eingangssignal des Verstärkers und das Ausgangssignal miteinander korreliert sind. Wird der Verstärker nicht in der Betriebssituation, sondern im Prüffeld beispielsweise mit einem 1-Kanal-Meßgerät ohne die in der DE 198 13 703 A1 beschriebene aufwendige Synchrondemodulation vermessen, so besteht eine meßtechnische Problematik darin, daß beispielsweise aufgrund unterschiedlicher Triggerzeiten keine exakt definierte zeitliche Korrelation zwischen dem Eingangssignal und dem Ausgangssignal des Verstärkers besteht.

Der Erfindung liegt deshalb die Aufgabe zugrunde, ein Verfahren zur Bestimmung von Parametern eines n-Tors anzugeben, bei welchem die Messung einer Ausgangs-Signalreihe ohne zeitlichen Bezug zu einer Eingangs-Signalreihe vorgenommen werden kann und insbesondere auf aufwendige Synchrondemodulatoren zur Erzeugung eines Referenzträgers verzichtet werden kann.

Die Aufgabe wird durch die kennzeichnenden Merkmale des Anspruchs 1 in Verbindung mit den gattungsbildenden Merkmalen gelöst.

Der Erfindung liegt die Erkenntnis zugrunde, daß der fehlende Zeitbezug zwischen dem Ausgangssignal und dem Eingangssignal durch Kreuzkorrelation des Ausgangssignals mit dem Eingangssignal hergestellt werden kann. Das Eingangssignal und das Ausgangssignal an dem n-Tor können durch unabhängige Meßreihen ohne Zeitbezug zueinander beispielsweise mit einem 1-Kanal-Meßgerät aufgenommen werden und der fehlende Zeitbezug wird erfindungsgemäß durch die Kreuzkorrelation erst bei der Auswertung hergestellt. Die beim Stand der Technik erforderliche gleichzeitige Messung des Eingangssignals und des Ausgangssignals und die synchrone Demodulation des Ausgangssignals mit einem aus dem Eingangssignal gewonnenen Referenzträger ist nicht notwendig, so daß das Meßverfahren erheblich vereinfacht werden kann.

Die Unteransprüche betreffen vorteilhafte Weiterbildungen des erfindungsgemäßen Verfahrens.

Die Kreuzkorrelation zur Ermittlung des Zeitversatzes zwischen dem Eingangssignal und dem Ausgangssignal wird vorzugsweise nicht durch eine Faltung im Zeitbereich sondern durch eine Multiplikation im Frequenzbereich durchgeführt. Dazu werden zunächst die Fouriertransformierte des Eingangssignals und die Fouriertransformierte des Ausgangssignals bestimmt und entweder die Fouriertransformierte des Eingangssignals mit den konjugiert Komplexen des Ausgangssignals multipliziert oder das Ausgangssignals mit der konjugiert Komplexen des Eingangssignals multipliziert, um einen sogenannten Zeitterm zu erhalten. Der Zeitterm besteht aus einem nur von der Frequenz, nicht jedoch von dem Zeitversatz abhängigen Betragsanteil und einem von der Frequenz und dem gesuchten Zeitversatz abhängigen Phasenanteil. Aus diesem Phasenanteil läßt sich der Zeitversatz durch Regression ermitteln. Das Ausgangssignal kann nun um den ermittelten Zeitversatz zeitlich verschoben werden, um eine Korrelation zwischen dem Eingangssignal und dem Ausgangssignal herzustellen. Dies kann ebenfalls im Frequenzbereich erfolgen, bevor das Ausgangssignal fourierrücktransformiert wird.

Unter Berücksichtigung des so ermittelten Zeitversatzes können beispielsweise die AM/AM-Kennlinie, also die Ausgangsleistung des Verstärkers als Funktion der Eingangsleistung, und die PM/AM-Kennlinie, also die Phasendifferenz zwischen Ausgangssignal und Eingangssignal als Funktion der Eingangsleistung, bestimmt werden. Die entsprechenden Vorverzerrungs-Kennlinien können durch Spiegelung an der jeweils idealen Kennlinie, also für die AM/AM-Kennlinie an einer Geraden mit konstanter Steigung und für die PM/AM-Kennlinie an der x-Achse, erhalten werden.

Nachfolgend wird ein Ausführungsbeispiel der Erfindung unter Bezugnahme auf die Zeichnung näher beschrieben. In der Zeichnung zeigen:

Fig. 1    den Pegelfehler und den Phasenfehler eines nicht durch Vorverzerrung kompensierten Hochfrequenzverstärkers,

Fig. 2    ein Blockschaltschema einer Meßvorrichtung zur Durchführung des erfindungsgemäßen Verfahrens,

Fig. 3    die AM/AM-Kennlinie eines Verstärkers ohne Berücksichtigung des Zeitversatzes zwischen Eingangssignal und Ausgangssignal,

Fig. 4    die AM/AM-Kennlinie eines Verstärkers mit Berücksichtigung des Zeitversatzes zwischen Eingangssignal und Ausgangssignal,

Fig. 5    den Phasenanteil und den Amplitudenanteil eines aus der Fouriertransfomierten des Eingangssignals und der Fouriertransformierten des Ausgangssignals gewonnenen Zeitterms,

Fig. 6    ein Beispiel für eine mit dem erfindungsgemäßen Verfahren gewonnen AM/AM-Kennlinie und dazu inverse Vorverzerrungs-AM/AM-Kennlinie und

Fig. 7    ein Beispiel für eine mit dem erfindungsgemäßen Verfahren gewonnene AM/PM-Kennlinie und die dazu gehörige Vorverzerrungs-AM/PM-Kennlinie.

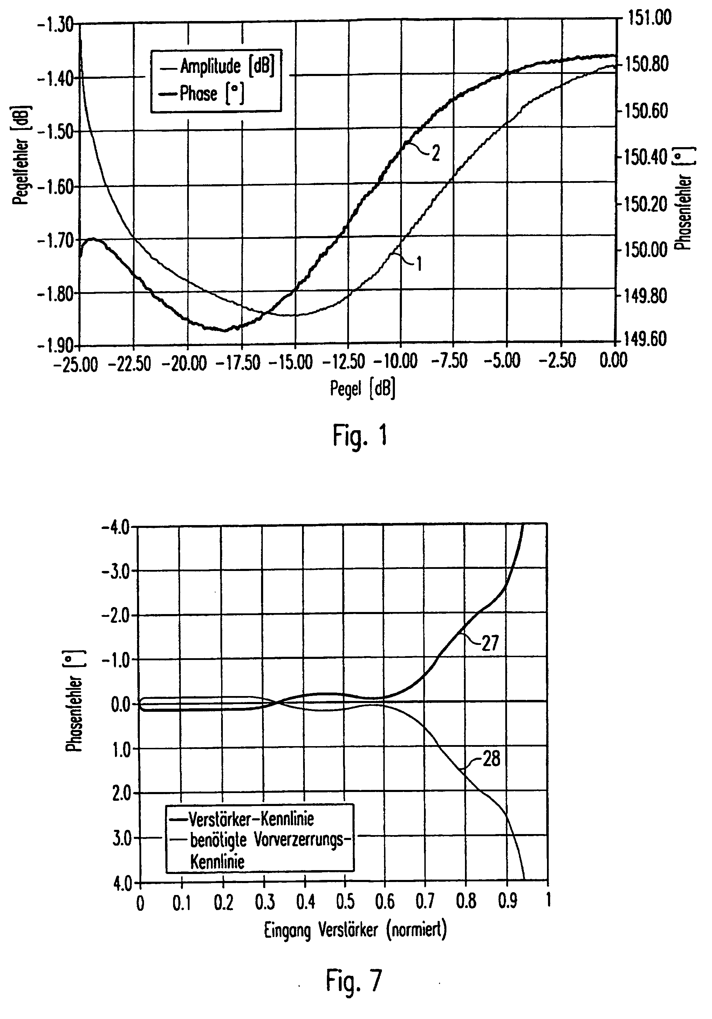

Fig. 1 zeigt den Pegelfehler und den Phasenfehler eines realen Hochfrequenz-Verstärkers. Als Pegelfehler wird eine Kennlinie bezeichnet, die die Abweichung der Ausgangssleistung des realen Verstärkers von der erwarteten Ausgangsleistung eines idealen Verstärkers als Funktion der Eingangsleistung darstellt. Auch der Phasenfehler, also die Abweichung der Phase des Ausgangssignals von der Phase des Eingangssignals ist keineswegs Null oder wenigstens konstant. Für den Betrieb des Verstärkers ist deshalb eine Vorverzerrung erforderlich. Hierfür müssen die sog. AM/AM-Kennlinie und die AM/PM-Kennlinie bestimmt werden. Unter der AM/AM-Kennlinie wird die Ausgangsamplitude bzw. die Ausgangsleistung als Funktion der Eingangsamplitude bzw. der Eingangsleistung verstanden. Unter der AM/PM-Kennlinie wird die Differenz zwischen der Phase des Ausgangssignals und der Phase des Eingangssignals als Funktion der Amplitude bzw. der Leistung des Eingangssignals verstanden.

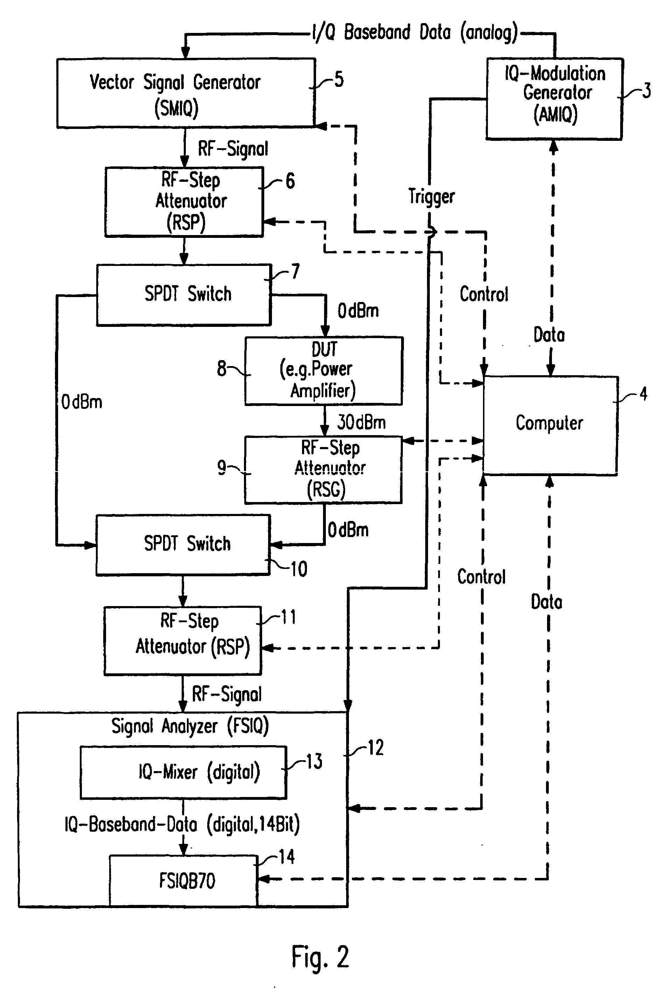

Fig. 2 zeigt eine Meßvorrichtung zur Bestimmung dieser Kennlinien. Ein IQ-Modulationsgenerator 3 wird von einem Steuer-Computer 4 mit den Modulationsdaten versorgt und erzeugt ein analoges I/Q-Basisband-Signal. Dieses wird an dem Vektor-Signal-Generator 5 zugeführt, welcher in Abhängigkeit von dem Modulationsdaten ein breitbandiges Hochfrequenzsignal erzeugt. Im Gegensatz zur konventionellen Netzwerkanalyse wird der Verstärker also mit einem dem Einsatzzweck entsprechenden, wirklichkeitsnahen Eingangssignal angesteuert, beispielsweise einem CDMA-Signal nach dem IS95 Standard. Dieses breitbandige Hochfrequenzsignal wird über einen einstellbaren Abschwächer 6 und einen ersten Schalter 7 dem zu messenden n-Tor, im hier dargestellten Ausführungsbeispiel einem Hochfrequenz-Verstärker 8, zugeführt. Die Ausgangsleistung des zu messenden n-Tors bzw. Hochfrequenz-Verstärkers 8 wird über einen einstellbaren Abschwächer 9 einem zweiten Schalter 10, einem weiteren einstellbaren Abschwächer 11 und schließlich einem Signalanalysator 12 zugeführt. In dem Signalanalysator 12 befindet sich ein IQ-Mischer 13, der das Eingangssignal in das IQ-Basisband zurückmischt, wo es von einem IQ-Demodulator 14 erfaßt werden kann. Das so gemessene Ausgangssignal wird dem Steuer-Computer 4 zur Auswertung zugeführt. Sämtliche vorstehend beschriebene Komponenten stehen über einen Steuerbus 15 mit dem Steuer-Computer 4 in Verbindung. Durch die am Ausgang des zu messenden Verstärkers 8 bzw. allgemein des zu messenden n-Tors vorgesehenen Abschwächer 9 und 10 wird erreicht, daß dem Signalanalysator 12 unabhängig von der Ansteuerung des zu messenden n-Tors ein Eingangspegel in etwa der gleichen Größenordnung zugeführt wird, so daß Meßbereichsumschaltungen und damit verbundene Meßungenauigkeiten vermieden werden.

Wird durch die Schalter 7 und 10 eine direkte Verbindung zwischen dem Vektor-Signal-Generator 5 und dem Signalanalysator 12 geschaffen, so kann in die bezüglich ihrer Amplitude stufenweise geänderte Eingangs-Signalreihe als aus diskreten Meßwerten bestehende Meßreihe gemessen werden. Für eine weitere Meßreihe werden die beiden Schalter 7 und 10 so umgeschaltet, daß das Signal den zu messenden Verstärker 8 passiert, so daß mit dem Signalanalysator 12 die Ausgangs-Signalreihe des Verstärkers 8 als aus diskreten Meßwerten bestehende Meßreihe bei Anlegung der vorher gemessenen Eingangs-Signalreihe an den Eingang des Verstärkers 8 gemessen wird. In diesem Fall arbeitet der Signalanalysator 12 als 1-Kanal-Meßgerät. Grundsätzlich kann jedoch auch ein 2-Kanal-Signalanalysator 12 mit zwei Eingangskanälen verwendet werden, wobei dann gleichzeitig die Eingangs-Signalreihe und die Ausgangs-Signalreihe des Verstärkers 8 gemessen wird. Wenn die Eingangs-Signalreihe von dem Vektor-Signal-Generator 5 mit hinreichender Genauigkeit erzeugt wird, kann auf deren Messung ggf. auch verzichtet werden.

Bei dem vorstehend beschriebenen Meßverfahren besteht kein fester Zeitbezug zwischen der Eingangs-Signalreihe und der Ausgangs-Signalreihe des zu vermessenden Verstärkers 8. Ein Grund für den Verlust dieses Zeitbezugs kann z. B. darin liegen, daß der IQ-Modulations-Generator 3 beim Starten einer Meßsequenz einen Trigger-Impuls auslöst, welcher den Signalanalysator 12 startet. Der Signalanalysator 12 tastet das Eingangssignal jedoch mit einer internen Taktfrequenz ab, die zu dem Triggerimpuls des IQ-Modulations-Generators 3 nicht korreliert ist. Der zufällige Zeitbezug des Triggerimpulses des IQ-Modulations-Generators 3 in Bezug auf das interne Taktsignal des Signalanalysators 12 führt für die beiden unabhängigen Meßreihen des Eingangssignals und des Ausgangssignals zu einem zufälligen Zeitversatz $\tau$ dieser beiden Meßreihen.

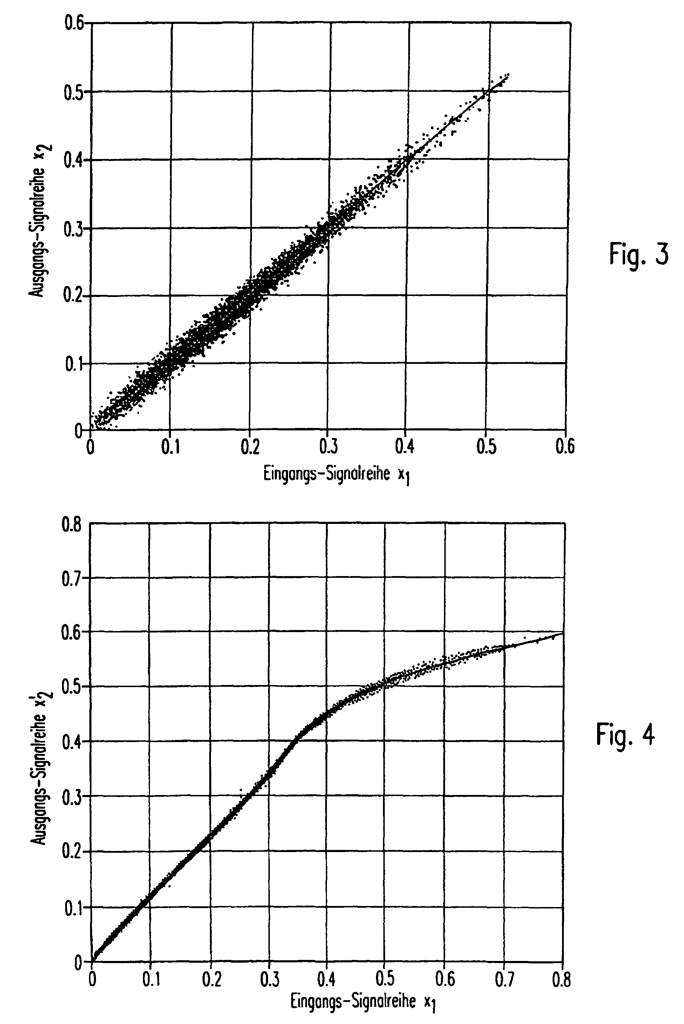

Fig. 3 zeigt die mit der anhand von Fig. 2 beschriebenen Meßvorrichtung gemessene Ausgangs-Singnalreihe des Verstärkers 8 in Relation zu der ebenfalls gemessenen Eingangs-Signalreihe. Durch den unbestimmten Zeitbezug dieser beiden Meßreihen ergibt sich eine unscharfe, verschmierte Kennlinie, die keine weitere Auswertung ermöglicht.

An dieser Stelle setzt die vorliegende Erfindung ein und schlägt vor, vor der Bestimmung der Kennlinie zunächst den fehlenden Zeitbezug zwischen der Ausgangs-Signalreihe und der Eingangs-Signalreihe herzustellen. Erfindungsgemäß wird vorgeschlagen, den Zeitversatz $\tau$ durch Kreuzkorrelation der Ausgangs-Signalreihe mit der Eingangs-Signalreihe zu ermitteln. Entsprechend einer bevorzugten erfindungsgemäßen Vorgangsweise wird diese Kreuzkorrelation nicht durch Faltung im Zeitbereich sondern durch Multiplikation im Frequenzbereich vorgenommen. Im einzelnen wird wie folgt vorgegangen:

Zunächst wird eine aus diskreten Datensymbolen bestehende Eingangs-Signalreihe $x_1(t)$ aufgenommen, indem die Schalter 7 und 10 so geschaltet werden, daß der zu vermessende Verstärker 8 bzw. allgemein das zu vermessende n-Tor umgangen wird. Dann wird eine Ausgangs-Signalreihe $x_2(t)$ aufgenommen, indem die Schalter 7 und 10 so geschaltet werden, daß das Signal über den zu vermessenden Verstärker 8 bzw. das zu vermessende n-Tor geleitet wird. Die Ausgangs-Signalreihe $x_2(t)$ unterscheidet sich von der Eingangs-Signalreihe $x_1(t)$ neben der Verzerrung durch einen zeitlichen Versatz $\tau$ :

$$x_2(t) = x_1(t-\tau) \qquad (1)$$

Dann wird die Fouriertransformierte $X_1(f)$ der

Eingangs-Signalreihe $x_1(t)$ und die Fouriertransformierte $X_2(f)$ der Ausgangs-Signalreihe $x_2(t-\tau)$ berechnet. Für die Fouriertransformierten gilt dabei folgende Beziehung:

$$X_2(f) = X_1(f)\cdot e^{-i2\pi f\tau} \qquad (2)$$

Berechnet man zu $X_2(f)$ das konjugiert Komplexe $X_2{}^*(f)$ und multipliziert die Fouriertransformierte $X_1(f)$ mit dem konjugiert Komplexen der Fouriertransformierten der Ausgangs-Signalreihe $X_2{}^*(f)$, so erhält man einen sogenannten Zeitterm ("Timing-Term") X:

$$X = X_1(f)\cdot X_2{}^*(f) = X_1(f)\cdot X_1{}^*(f)\cdot e^{i2\pi f\tau} \qquad (3)$$

Alternativ kann auch das konjugiert Komplexe der Eingangs-Signalreihe $X_1{}^*(f)$ mit der Fouriertransformierten der Ausgangs-Signalreihe $X_2(f)$ multipliziert werden. Dann erhält man als Zeitterm X Folgendes:

$$X = X_2(f)\cdot X_1{}^*(f) = X_2(f)\cdot X_2{}^*(f)\cdot e^{-i2\pi f\tau} \qquad (4)$$

Über die Korrespondenz $X_1\cdot X_1{}^* = |X_1|^2$ bzw. $X_2\cdot X_2{}^* = |X_2|^2$ erhält man:

$$X = X_1(f)\cdot X_2{}^*(f) = |X_1(f)|^2\cdot e^{i2\pi f\tau} \qquad (5)$$

bzw.

$$X = X_2(f)\cdot X_1{}^*(f) = |X_2(f)|^2\cdot e^{-i2\pi f\tau}. \qquad (6)$$

Durch Abspaltung des Phasenanteils arg(X) des komplexen Zeitterms X erhält man:

$$\arg(X) = 2\pi f\tau \qquad (7)$$

bzw.

$$\arg(X) = -2\pi f\tau. \qquad (8)$$

Während die Verzerrung in dem Amplitudenanteil des Zeitterms X beinhaltet ist, beinhaltet der Phasenanteil den zeitlichen Versatz $\tau$.

Da die Frequenz f als Laufvariable bzw. Index der diskreten Stützstellen bekannt ist, läßt sich der Zeitversatz $\tau$ zwischen der Ausgangs-Signalreihe $X_2$ und der Eingangs-Signalreihe $X_1$ bestimmen.

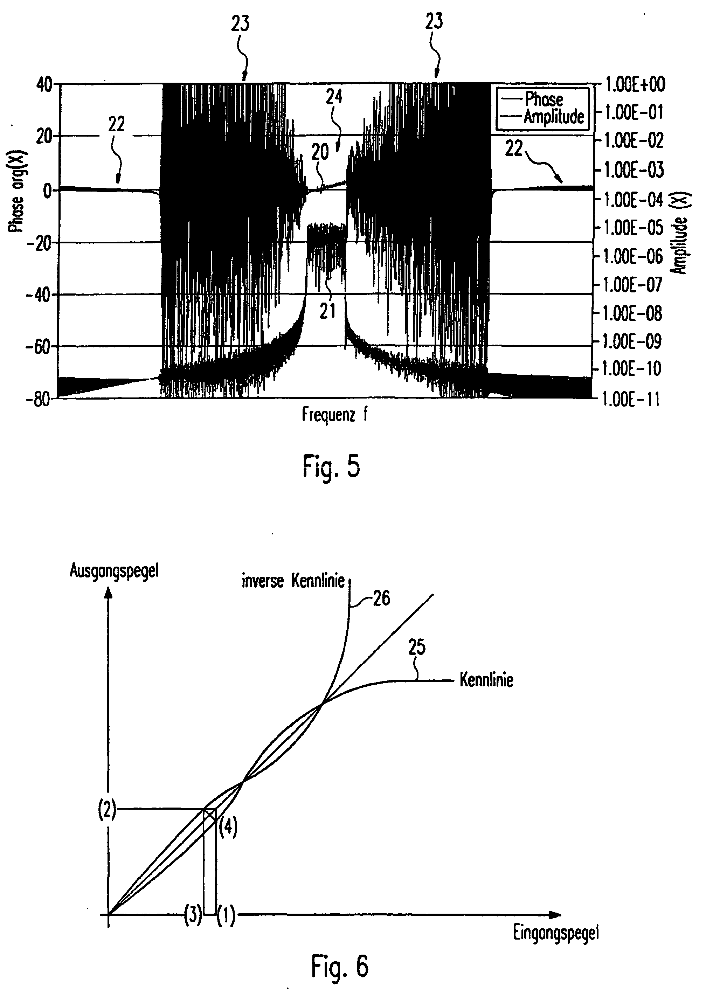

Fig. 5 zeigt den Phasenanteil 20 und den Amplitudenanteil 21 des Zeitterms X als Funktion der Frequenz f. Dabei lassen sich drei Bereiche unterscheiden.

Ein äußerer Bereich 22 befindet sich außerhalb der Bandbreite der Meßvorrichtung. Ein mittlerer Bereich 23 befindet sich bereits innerhalb der Bandbreite der Meßvorrichtung, jedoch liegt hier noch keine Korrelation zwischen der Eingangs-Signalreihe $x_1$ und der Ausgangs-Signalreihe $x_2$ vor, da sich die Messung hier außerhalb der Kanalbandbreite des Modulationssignals befindet. Der Zeitterm X ist deshalb bezüglich der Phase verrauscht. Der Bereich 24 befindet sich innerhalb des Übertragungskanals, also innerhalb der Kanalbandbreite des Modulationssignals. Hier liegt eine deutliche Korrelation zwischen der gemessenen Ausgangs-Signalreihe $x_2$ und der gemessenen Eingangs-Signalreihe $x_1$ vor. Man erkennt, daß der Phasenanteil arg(X) des Zeitterms X im dargestellten Ausführungsbeispiel linear mit der Frequenz ansteigt. Dies ist auch zu erwarten, da bei endlicher elektrischer bzw. mechanischer Länge des Verstärkers 8, bzw. allgemein des zu vermessenden n-Tors, die Phasenverschiebung zwischen Eingangssignal und Ausgangssignal linear von der Frequenz abhängig ist. In diesem Fall kann der gesuchte Zeitversatz $\tau$ durch lineare Regression ermittelt werden, indem in dem korrelierten Bereich 24 durch Regression eine Gerade mit konstanter Steigung gelegt wird, wobei die Steigung $2\pi\tau$ beträgt.

Es ist auch denkbar, daß das zu vermessende n-Tor Elemente beinhaltet, die einen frequenzabhängigen Zeitversatz $\tau(f)$ zwischen dem Ausgangssignal und dem Eingangssignal hervorrufen. Dann wäre der funktionelle Zusammenhang innerhalb des korrelierten Bereichs 24 zwischen dem Phasenanteil arg(X) des Zeitterms (X) und der Frequenz f keine Gerade sondern eine Funktion höherer Ordnung, die ebenfalls durch entsprechende Regression ermittelt werden kann.

Es zeigt sich ferner, daß innerhalb des korrelierten Bereichs 24 die Schwankung des Phasenanteils arg(X) um so größer ist, je kleiner die zugehörige Amplitude des Zeitterms X ist. Bei der Regression können deshalb entsprechend einer Weiterbildung der Erfindung die ermittelten Stützstellen des Phasenanteils arg(X) des Zeitterms X mit einer Gewichtung eingehen, die von der Amplitude des Zeitterms X abhängt.

Nachdem der Zeitversatz $\tau$ ermittelt ist, kann die Ausgangs-Signalreihe $x_2$ um diesen Zeitversatz $\tau$ zeitlich verschoben werden, um eine zeitliche Korrelation zwischen dem Eingangssignal $x_1$ und dem Ausgangssignal $x_2$ herzustellen. Diese zeitliche Verschiebung wird bevorzugt nicht durch Faltung im Zeitbereich sondern durch Multiplikation im Frequenzbereich vorgenommen. Dazu wird zur Phase der Fouriertransformierten der Ausgangs-Signalreihe $X_2(f)$ der Term $i2\pi f\tau$ addiert. Anschließend wird die so modifizierte Fouriertransformierte der Ausgangs-Signalreihe fourierrücktransformiert, so daß die verschobene Ausgangs-Signalreihe $x'_2(t)$ im Zeitbereich vorliegt. Dabei ist zu betonen, daß eine zunächst naheliegende einfache Verschiebung der abgetasteten Stützstellen der Ausgangs-Signalreihe $x_2$ um Vielfache der Abtastperiode nicht zum Ziel führt, da die erfindungsgemäße Verschiebung um Bruchteile der Abtastperiode vorgenommen werden muß, was im Zeitbereich nur durch Interpolation möglich ist.

Fig. 4 zeigt die um den Zeitversatz $\tau$ verschobene Ausgangs-Signalreihe $x_2$ als Funktion der Eingangs-Signalreihe $x_1$. Wie ein Vergleich mit Fig. 3 zeigt, ergibt die erfindungsgemäße Berücksichtigung des Zeitversatzes $\tau$ eine wesentlich bessere Korrelation zwischen der Eingangs-Signalreihe $x_1$ und der Ausgangs-Signalreihe $x_2$, so daß die Relation zwischen Eingangs-Signalreihe $x_1$ und Ausgangs-Signalreihe $x_2$ zur Kennlinienbestimmung bzw. zur Bestimmung sonstiger Parameter herangezogen werden kann.

Eine dieser Kennlinien ist die sogenannte AM/AM-Kennlinie also der Pegel des Ausgangssignals als Funktion des Eingangssignal (entweder in Bezug auf die Amplitude oder in Bezug auf die Leistung, die durch Quadrieren der Amplitude erhalten werden kann). Diese AM/AM-Kennlinie kann aus der in Fig. 4 dargestellten Relation zwischen Eingangs-Signalreihe $x_1$ und zeitlich verschobener Ausgangs-Signalreihe $x'_2$ durch Regression ermittelt werden, indem ein Polynom endlicher Ordnung so durch die Meßpunkte hindurchgelegt wird, daß die Summe der Quadrate der Fehlerabweichungen minimiert wird. Solche Verfahren sind bekannt und werden hier deshalb nicht im Einzelnen beschrieben. In Fig. 4 und Fig. 6 ist die durch Regression erhaltene AM/AM-Kennlinie 25 eingezeichnet.

Um diese nichtlineare AM/AM-Kennlinie zu kompensieren, muß dem Hochfrequenz-Verstärker 8 (bzw. allgemein dem n-Tor) ein Vorverzerrer vorgeschaltet werden, der eine inverse Vorverzerrungs-AM/AM-Kennlinie aufweist. Um die geeignet Vorverzerrungs-AM/AM-Kennlinie zu erhalten, muß die gemessene AM/AM-Kennlinie an der idealen Kennlinie des Verstärkers bzw. n-Tors gespiegelt werden. Sind der Eingangs-Pegel und der Ausgangs-Pegel auf den größte vorkommenden Eingangs-Pegel und den größten vorkommenden Ausgangs-Pegel normiert, so ist diese ideale Kennlinie die Winkelhalbierende zwischen x-Achse und y-Achse in Fig. 6. Die inverse Vorverzerrungs-AM/AM-Kennlinie 26 ist in Fig. 6 ebenfalls eingezeichnet.

Zur Kompensation des Phasenfehlers des Verstärkers 8 bzw. allgemein des n-Tors wird in ähnlicher Weise vorgegangen. Zunächst wird eine sogenannte AM/PM-Kennlinie ermittelt, indem die Phasendifferenz zwischen der Ausgangs-Signalreihe $x_2$ und der Eingangs-Signalreihe $x_1$ als Funktion der Eingangs-Signalreihe $x_1$ aufgetragen wird und durch Regression mit einem Polynom endlicher Ordnung ein funktionaler Zusammenhang zur durch Minimierung der Summe der Fehlerquadrate zugeordnet wird. Fig. 7 zeigt eine solche PM/AM-Kennlinie 27. Man erkennt, daß die Phasenfehler mit zunehmenden Eingangs-Pegel zunehmen. Die ideale AM/PM-Kennlinie ist die x-Achse (keine Abweichung der Phase des Ausgangssignals von der Phase des Eingangssignals bei allen Eingangs-Pegeln). Die Vorverzerrungs-AM/PM-Kennlinie erhält man deshalb durch Spiegelung der AM/PM-Kennlinie an der x-Achse. Die so ermittelte Vorverzerrungs-AM/PM-Kennlinie 28 ist in Fig. 7 ebenfalls eingezeichnet. Um den Phasenfehler des Verstärkers 8 bzw. des n-Tors zu kompensieren, muß diesem ein Vorverzerrer vorgeschaltet werden, der die Vorverzerrungs-AM/PM-Kennlinie 28 aufweist.

Die Erfindung ist nicht auf das dargestellte Ausführungsbeispiel beschränkt und eignet sich allgemein zur Bestimmung von Parametern eines n-Tors, beispielsweise auch eines Mischer (3-Tor). Die Eingangs-Signalreihe $x_1$ und die Ausgangs-Signalreihe $x_2$ können mit einem 2-Kanal-Meßgerät auch gleichzeitig bestimmt werden. Anstatt einer Regression mit Polynomen endlicher Ordnung kann auch eine Look-Up-Tabelle, eine Spline-Interpolation oder ein anderes bekanntes Verfahren verwendet werden. Im Gegensatz zu einer konventionellen Netzwerkanalyse erlaubt das erfindungsgemäße Verfahren eine Ansteuerung des Verstärkers bzw. n-Tors mit einer wirklichkeitsnahen Aussteuerung, beispielsweise einem Betriebssignal wie einem modulierten CMDA-Signal nach dem IS95-Standard. Durch die inverse Vorverzerrung des Aussteuersignals können sowohl die Signal-Eigenschaften ( z. B. Streuung in Nachbarkanäle) als auch die Modulationsqualität des Ausgangssignal des Meßobjekts entscheidend verbessert werden.

## Patentansprüche

1. Verfahren zur Bestimmung von Parametern, insbesondere von Kennlinien (25, 27), eines n-Tors, insbesondere eines Verstärkers (8), durch Anlegen zumindest einer modulierten Eingangs-Signalreihe $x_1$(t) mit unterschiedlichen Amplituden und Messen zumindest einer Ausgangs-Signalreihe $x_2$(t+τ), unter Berücksichtigung eines Zeitversatzes τ, den die Ausgangs-Signalreihe $x_2$(t+τ) gegenüber der Eingangs-Signalreihe $x_1$(t) aufweist, **dadurch gekennzeichnet,** **daß** der Zeitversatz τ durch Kreuzkorrelation der Ausgangs-Signalreihe $x_2$(t+τ) mit der Eingangs-Signalreihe $x_1$(t) ermittelt wird.

2. Verfahren nach Anspruch 1, **dadurch gekennzeichnet,** **daß** der Zeitversatz τ ermittelt wird, indem

   - die Fouriertransformierte $X_1$(f) der Eingangs-Signalreihe $x_1$(t) bestimmt wird,
   - die Fouriertransformierte $X_2$(f) der Ausgangs-Signalreihe $x_2$(t+τ) bestimmt wird,
   - das konjugiert Komplexe $X^*_2$(f) bzw. $X^*_1$(f) der Fouriertransformierten der Ausgangs-Signalreihe $X_2$(f) oder der Eingangs-Signalreihe $X_1$(f)

berechnet wird,
   - ein Zeitterm

$$X = X_1(f) \cdot X^*_2(f) = X_1(f) \cdot X^*_1(f) \cdot e^{i2\pi f\tau}$$

bzw.

$$X = X_2(f) \cdot X^*_1(f) = X_2(f) \cdot X^*_2(f) \cdot e^{-i2\pi f\tau}$$

durch Multiplikation der Fouriertransformierte $X_1$(f) der Eingangs-Signalreihe mit dem konjugiert Komplexen $X^*_2$(f) der Fouriertransformierten der Ausgangs-Signalreihe oder der Fouriertransformierte $X_2$(f) der Ausgangs-Signalreihe mit dem konjugiert Komplexen $X^*_1$(f) der Fouriertransformierten der Eingangs-Signalreihe berechnet wird,
   - der Phasenanteil arg(X) = 2πfτ des komplexen Zeitterms X abgespalten wird, und
   - der Zeitversatz τ aus dem Phasenanteil arg(X) des Zeitterms X durch Regression ermittelt wird.

3. Verfahren nach Anspruch 2, **dadurch gekennzeichnet,** **daß** die Regression des Phasenanteils arg(X) des Zeitterms X im Frequenbereich erfolgt.

4. Verfahren nach Anspruch 2 oder 3, **dadurch gekennzeichnet,** **daß** die Ausgangs-Signalreihe $x_2$(t+τ) um den ermittelten Zeitversatz τ zeitlich verschoben wird, um eine verschobene Ausgangs-Signalreihe $x'_2$(t) zu erzeugen.

5. Verfahren nach Anspruch 4, **dadurch gekennzeichnet,** **daß** die zeitliche Verschiebung dadurch vorgenommen wird, daß zur Phase der Fouriertransformierten der Ausgangs-Signalreihe $X_2$(f) der Term i2πfτ addiert wird, wobei f die Frequenz und τ den Zeitversatz bedeutet, und dann eine Fourierrücktransformation der Ausgangs-Signalreihe durchgeführt wird.

6. Verfahren nach Anspruch 4 oder 5, **dadurch gekennzeichnet,** **daß** eine AM/AM-Kennlinie (25) des n-Tors ermittelt wird, indem die um den ermittelten Zeitversatz τ zeitlich verschobene Ausgangs-Signalreihe $x_2$'(t) in Relation zu der Eingangs-Signalreihe $x_1$(t) gesetzt und ein funktionaler Zusammenhang durch Regression ermittelt wird.

7. Verfahren nach Anspruch 4 oder 5, **dadurch gekennzeichnet,**

**daß** eine PM/AM-Kennlinie (27) des n-Tors ermittelt wird, indem die Phasendifferenz zwischen der Phase der um den ermittelten Zeitversatz $\tau$ zeitlich verschobene Ausgangs-Signalreihe $x_2'(t)$ und der Phase der Eingangs-Signalreihe $x_1'(t)$ in Relation zu der Eingangs-Signalreihe $x_1'(t)$ gesetzt wird und ein funktionaler Zusammenhang durch Regression ermittelt wird.

8. Verfahren nach Anspruch 6 oder 7,
**dadurch gekennzeichnet,**
**daß** die Regression durch Polynom-Regression erfolgt.

9. Verfahren nach einem der Ansprüche 6 bis 8,
**dadurch gekennzeichnet,**
**daß** eine Vorverzerrungs-AM/AM-Kennlinie (26) und/oder eine Vorverzerrungs-PM/AM-Kennlinie (28) ermittelt wird, indem die AM/AM-Kennlinie (25) und/oder die PM/AM-Kennlinie (27) an der jeweils idealen Kennlinie gespiegelt wird.

10. Verfahren nach einem der Ansprüche 1 bis 9,
**dadurch gekennzeichnet,**
**daß** eine Messung der Eingangs-Signalreihe $x_1(t)$ und der Ausgangs-Signalreihe $x_2(t+\tau)$ mit einem 1-Kanal-Meßgerät zeitlich hintereinander erfolgt.

11. Verfahren nach einem der Ansprüche 1 bis 10,
**dadurch gekennzeichnet,**
**daß** eine Eingangs-Signalreihe $x_1(t)$ mit einem breitbandigen Spektrum, insbesondere ein Multiträgersignal, wie ein digital moduliertes CDMA-Signal, ein DAB-Signal oder ein DVB-Signal verwendet wird.

**Claims**

1. Method of determining parameters, and particularly characteristics (25, 27), of an n-port network, and particularly an amplifier (8), by applying at least one modulated input signal train $x_1(t)$ of differing amplitudes and measuring at least one output signal train $x_2(t+\tau)$ while making allowance for a temporal displacement $\tau$ which the output signal train $x_2(t+\tau)$ has in relation to the input signal train $x_1(t)$,
**characterized in that**
the temporal displacement $\tau$ is found by cross-correlating the output signal train $x_2(t+\tau)$ with the input signal train $x_1(t)$.

2. Method according to Claim 1,
**characterized in that**
the temporal displacement $\tau$ is found by

- determining the Fourier transform $X_1(f)$ of the input signal train $x_1(t)$,

- determining the Fourier transform $X_2(f)$ of the output signal train $x_2(t+\tau)$,

- calculating the conjugate complex $X^*_2(f)$ or $X^*_1(f)$ of the Fourier transform $X_2(f)$ of the output signal train or $X_1(f)$ of the input signal train,

- calculating a timing term

$$X = X_1(f) \cdot X^*_2(f) = X_1(f) \cdot X^*_1(f) \cdot e^{i2\pi f\tau}$$

or

$$X = X_2(f) \cdot X^*_1(f) = X_2(f) \cdot X^*_2(f) \cdot e^{-i2\pi f\tau}$$

by multiplying the Fourier transform $X_1(f)$ of the input signal train by the conjugate complex $X^*_2(f)$ of the Fourier transform of the output signal train or the Fourier transform $X_2(f)$ of the output signal train by the conjugate complex $X^*_1(f)$ of the Fourier transform of the input signal train,

- extracting the phase component $\arg(X) = 2\pi f\tau$ of the complex timing term X, and

- finding the temporal displacement $\tau$ from the phase component $\arg(X)$ of the timing term X by regression.

3. Method according to Claim 2,
**characterized in that**
the regression of the phase component $\arg(X)$ of the timing term X takes place in the frequency domain.

4. Method according to Claim 2 or 3,
**characterized in that**
the output signal train $x_2(t+\tau)$ is shifted in time by the found temporal displacement $\tau$, to generate a shifted output signal train $x'_2(t)$.

5. Method according to Claim 4,
**characterized in that**
the shift in time is made by adding the term $i2\pi f\tau$ to the phase of the Fourier transform of the output signal train $X_2(f)$, where f is frequency and $\tau$ the temporal displacement, and then carrying out a Fourier back-transformation of the output signal train.

6. Method according to Claim 4 or 5,
**characterized in that**
an AM/AM characteristic (25) of the n-port network is found by relating the output signal train $x_2'(t)$, which has been shifted in time by the found temporal displacement $\tau$, to the input signal train $x_1(t)$, and finding a functional relationship by regression.

7. Method according to Claim 4 or 5,
**characterized in that**
a PM/AM characteristic (27) of the n-port network is found by relating the difference between the phase of the output signal train $x_2'(t)$, which has been shifted in time by the found temporal displacement $\tau$, and the phase of the input signal train $x_1'(t)$, to the input signal train $x_1'(t)$, and finding a functional relationship by regression.

8. Method according to Claim 6 or 7,
**characterized in that**
the regression is performed by polynomial regression.

9. Method according to one of Claims 6 to 8,
**characterized in that**
a pre-distortion AM/AM characteristic (26) and/or a pre-distortion PM/AM characteristic (28) is found by mirror-imaging the AM/AM characteristic (25) and/or the PM/AM characteristic (27) about the respective ideal characteristic.

10. Method according to one of Claims 1 to 9,
**characterized in that**
the input signal train $x_1(t)$ and the output signal train $x_2(t+\tau)$ are measured in temporal succession using a one-channel measuring device.

11. Method according to one of Claims 1 to 10,
**characterized in that**
an input signal train $x_1(t)$ having a wideband spectrum is used, and in particular a multi-carrier signal such as a digitally modulated CDMA signal, a DAB signal or a DVB signal.

**Revendications**

1. Procédé pour la détermination de paramètres, en particulier de courbes caractéristiques (25, 27), d'une porte n, en particulier d'un amplificateur (8) par application d'au moins une série de signaux d'entrée modulés $x_1(t)$ avec des amplitudes différentes et mesure d'au moins une série de signaux de sortie $x_2(t+\tau)$, compte tenu d'un décalage dans le temps $\tau$, que la série de signaux de sortie $x_2(t+\tau)$ présente par rapport à la série de signaux d'entrée $x_1(t)$,
**caractérisé en ce que**,
le décalage dans le temps $\tau$ est déterminé par corrélation croisée de la série de signaux de sortie $x_2(t+\tau)$ avec la série de signaux d'entrée $x_1(t)$.

2. Procédé selon la revendication 1,
**caractérisé en ce que** le décalage dans le temps $\tau$ est calculé

- en déterminant la transformée de Fourier $x_1(f)$ de la série de signaux d'entrée $x_1(t)$,
- en déterminant la transformée de Fourier $x_2(f)$

de la série de signaux de sortie $x_2(t+\tau)$,
- le complexe conjugué $X^*_2(f)$ ou $X^*_1(f)$ de la transformée de Fourier de la série de signaux de sortie $X_2(f)$ ou de la série de signaux d'entrée $X_1(f)$ est calculé,
- un terme de temps

$$X = X_1(f).X^*_2(f) = X_1(f).X^*_1(f).e^{i2\pi f\tau}$$

ou

$$X = X_2(f).X^*_1(f) = X_2(f).X^*_2(f).e^{-i2\pi f\tau}$$

est calculé par multiplication de la transformée de Fourier $X_1(f)$ de la série de signaux d'entrée par le complexe conjugué $X^*_2(f)$ de la transformée de Fourier de la série de signaux de sortie ou de la transformée de Fourier $X_2(f)$ de la série de signaux de sortie par le complexe conjugué $X^*_1(f)$ de la transformée de Fourier de la série de signaux d'entrée,
- la partie de phase $\arg(X) = 2\pi f\tau$ du terme de temps X complexe est divisée et
- le décalage dans le temps $\tau$ est calculé par régression à partir de la partie de phase $\arg(X)$ du terme de temps X.

3. Procédé selon la revendication 2,
**caractérisé en ce que**
la régression de la partie de phase $\arg(X)$ du terme de temps X s'effectue dans la plage de fréquences.

4. Procédé selon la revendication 2 ou 3,
**caractérisé en ce que**
la série de signaux de sortie $x_2(t+\tau)$ est déplacée dans le temps du décalage de temps $\tau$ calculé, afin de générer une série de signaux de sortie $x'_2(t)$ décalés.

5. Procédé selon la revendication 4,
**caractérisé en ce que** le décalage dans le temps est effectué en ajoutant le terme $i2\pi f\tau$ à la phase de la transformée de Fourier de la série de signaux de sortie $X_2(f)$, f représentant la fréquence et $\tau$ le décalage dans le temps, et en effectuant ensuite une retransformation de Fourier de la série de signaux de sortie.

6. Procédé selon la revendication 4 ou 5,
**caractérisé en ce que**
une courbe caractéristique MA/MA (25) de la porte n est déterminée en mettant la série de signaux de sortie $x_2'(t)$ décalée dans le temps du décalage de temps $\tau$ calculé en relation avec la série de signaux d'entrée $x_1(t)$ et en calculant un rapport fonctionnel par régression.

**7.** Procédé selon la revendication 4 ou 5, **caractérisé en ce que** une courbe caractéristique MP/MA (27) de la porte n est déterminée en mettant la différence de phase entre la phase de la série de signaux de sortie $x_2'$ (t) déplacée dans le temps du décalage de temps $\tau$ calculé et la phase de la série de signaux d'entrée $x_1'$(t) en relation avec la série de signaux d'entrée $x_1'$(t) et en déterminant un rapport fonctionnel par régression.

**8.** Procédé selon la revendication 6 ou 7, **caractérisé en ce que** la régression s'effectue par régression de polynôme.

**9.** Procédé selon l'une quelconque des revendications 6 à 8, **caractérisé en ce que** une courbe caractéristique MA/MA de prédistorsion (26) et/ou une courbe caractéristique MP/MA de prédistorstion (28) est déterminée en réfléchissant la courbe caractéristique MA/MA (25) et/ou la courbe caractéristique MP/MA (27) sur la courbe caractéristique idéale respective.

**10.** Procédé selon l'une quelconque des revendications 1 à 9, **caractérisé en ce que** une mesure de la série de signaux d'entrée $x_1$(t) et de la série de signaux de sortie $x_2$(t+$\tau$)s'effectue avec un appareil de mesure à un canal de façon consécutive dans le temps.

**11.** Procédé selon l'une quelconque des revendications 1 à 10, **caractérisé en ce que** on utilise une série de signaux d'entrée $x_1$(t) avec un spectre à large bande, en particulier un signal de porteuses multiples, comme un signal ARMC modulé de façon numérique, un signal DAB ou un signal DVB.

EP 1 273 098 B1

Fig. 1

Fig. 7

10

Fig. 2

Fig. 3

Fig. 4

Fig. 5

Fig. 6